(19) Europäisches Patentamt

European Patent Office

Office européen des brevets

(11) **EP 1 198 355 B1**

(12) **EUROPÄISCHE PATENTSCHRIFT**

(45) Veröffentlichungstag und Bekanntmachung des Hinweises auf die Patenterteilung:
**02.04.2003 Patentblatt 2003/14**

(51) Int Cl.⁷: **B41N 1/00**, B41N 1/16, G03F 5/16

(21) Anmeldenummer: **00945782.1**

(22) Anmeldetag: **20.06.2000**

(86) Internationale Anmeldenummer:
**PCT/EP00/05664**

(87) Internationale Veröffentlichungsnummer:
**WO 01/000422 (04.01.2001 Gazette 2001/01)**

(54) **FORM EINES DRUCKELEMENTES BEIM OFFSET-DRUCKVERFAHREN**

FORM OF A PRINTING ELEMENT IN AN OFFSET PRINTING PROCESS

FORME D'UN ELEMENT D'IMPRESSION EN IMPRESSION OFFSET

(84) Benannte Vertragsstaaten:
**AT BE CH CY DE DK ES FI FR GB GR IE IT LI LU MC NL PT SE**

(30) Priorität: **29.06.1999 DE 19929901**

(43) Veröffentlichungstag der Anmeldung:
**24.04.2002 Patentblatt 2002/17**

(73) Patentinhaber: **Sandy Screen AG**
**4051 Basel (CH)**

(72) Erfinder: **HÄNY, Thomas**
**D-60385 Frankfurt am Main (DE)**

(74) Vertreter: **Neumann, Gerd, Dipl.-Ing.**
**Alb.-Schweitzer-Strasse 1**
**79589 Binzen (DE)**

(56) Entgegenhaltungen:
EP-A- 0 527 655          EP-A- 0 825 490
DE-A- 2 917 242          DE-A- 3 711 838
FR-A- 1 382 265

EP 1 198 355 B1

# EP 1 198 355 B1

## Beschreibung

Die Erfindung bezieht sich auf eine Form eines Druckelementes einer Vielzahl von rundum durch Stege voneinander getrennten Druckelementen an einer Druckeinheit beim Offset-Druckverfahren wie insbesondere dem rotativen Offsetdruck, wobei das jeweilige Druckelement eine geometrische, vieleckige Form aufweist.

Seit Beginn der Reprotechnik für das Offsetdruckverfahren bestand der Wunsch, anstelle der fotomechanischen Raster die alte, rasterlose Lithographie zu imitieren oder zumindest so nahe wie möglich an diese heranzukommen. Mit der Entwicklung der Fotolithographie wurde es immer deutlicher, dass mit den technisch konventionellen Rastern zwar eine relativ hohe Druckqualität erreicht werden kann, nicht aber die Nachahmung der alten Litho-Drucke. Die fotomechanischen Raster wie z. B. der Gradar- oder der Magenta-Raster eignen sich sehr gut für die neu entwickelte Fotolithographie und auch für die Reprotechnik. Diesen Rasterarten haften aber immer gewisse technischen Mängel wie Rasterabrisse, Moirébildung, Sekundär- Moirébildung und Rosetten-Bildung an. Nach wie vor besteht der Wunsch, die Originallithographie, also den Steindruck, rasterlos mit nur der Körnung der Steinoberfläche als Druckelement für den Offsetdruck zu ermöglichen.

Es besteht folglich zunächst ganz allgemein die Aufgabe, rasterlose Lithos herzustellen. Zunächst war die Idee, das Farbkorn eines Dias als Basis zu verwenden und mittels Farbauszug diese Körnung zu selektionieren und als Druckelement einzusetzen. Der Versuch scheitert an den unzulänglichen fototechnischen Materialien. Ein Teilerfolg konnte mit Computerprogrammen und PostSript-Seitenbeschreibungs Programmen erzielt werden. Da diese Rasterprogramme aber einem gesteuerten Zufallsgenerator unterliegen, besteht das Problem, dass je feiner die Auflösung der gewählten Einheiten ist, desto schwieriger die Berechnung der jeweiligen Gradationskurve ist. Wegen dieser Problematik ist diese Rasterart - wie der Cristall-, der Diamond-Screenoder der Harlequin-HD-Screen-Raster - für die Zeitungsrotationsdruckmaschinen nicht geeignet.

Es war zu der konventionellen Rastertechnik für den Offsetdruck zurückzukehren. Beim rotativen Offsetdruck wird eine Druckplatte auf einen Zylinder gespannt. Der Zylinder arbeitet mit einem mit einem Gummituch bezogenen weiteren Zylinder zusammen und dieser wiederum mit einem Gegendruckzylinder, über den das zu bedruckende Papier geführt ist. Die druckenden Stellen der Druckplatte sind so präpariert, dass sie Wasser abstoßen und die fettige Druckfarbe annehmen. Die nicht druckenden Stellen sind wasserfreundlich präpariert und stoßen die fettige Farbe ab. Beim Drucken wird zuerst die ganze Druckplatte angefeuchtet, wobei nur die nichtdruckenden, wasserfreundlichen Stellen das Wasser annehmen. Die damit teilweise feuchte Druckplatte läuft dann an Farbwalzen vorbei, welche die fetthaltige Farbe auf die nicht feuchten Stellen der Druckplatte übertragen. Das Druckbild wird dann auf den Gummituchzylinder und von dem auf das zu bedruckende Papier übertragen.

Die zu färbenden-Stellen eines Druckbildes sind in Druckelemente aufgeteilt, die mit dem bloßen Auge nicht zu erkennen sind. Jedes Druckelement ist von den benachbarten durch Stege getrennt. Die Stege werden nicht gefärbt. Je größer die Gesamtfläche der Stege in einem Bildpunkt ist, desto heller erscheint der Bildpunkt. Der Anteil der gefärbten Fläche an der Gesamtfläche eines Bildpunktes definiert einen Grauwert, den Halbtonwert des Bildpunktes, und wird normalerweise in Prozenten angegeben.

Mittels eines Rasters mit einer Vielzahl von darauf verteilten Druckelementen können durch Variieren der Druckelementgröße unterschiedliche Halbtonwerte simuliert werden. Es ist bekannt, die Druckelemente als Quadrate, als kreisrunde Flächen, als elliptische oder sonst wie geometrische Flächen zu bilden. Die Konturenschärfe der Bilder konnte bei der technisch möglichen Feinheit bei den bekannten Druckelementformen nicht voll befriedigen. Dies liegt daran, dass schon bei mittleren Druckelementgrößen, also bei mittlerem Halbtonwert des betreffenden Bildbereichs, ein Punkteschluss auftritt, so dass die Konturenschärfe sowie die Schattierungsverläufe des Druckbildes unbefriedigend sind. Bei der zu findenden Druckelementform muss der Punkteschluss soweit wie möglich nach "hinten" zur Tiefe hin gelegt, und es muss die neue Druckelementform über Gradationskurven perfekt gesteuert werden können.

Eine Lösung dieses Problems ist durch die Druckelementform nach der EP-A-0 825 490 bekannt. In jeder Zelle der schachbrettartig angeordneten imaginären Rasterzellen ist je ein Druckelement angeordnet, dass bei über die Rasterzellen gleichbleibendem beliebigem Tonwert für alle Punkte der Begrenzungslinien eines Druckelementes der jeweils kürzeste Abstand zum benachbarten Druckelement zumindest annähernd gleich groß ist. Dabei soll das Druckelement eine im wesentlichen rhomboide Fläche aufweisen, deren Begrenzungslinien derart bogenförmig verlaufen, dass sie zwei einander diagonal gegenüberliegende spitze Ecken und zwei einander diagonal gegenüberliegende runde oder stumpfe Ecken ausbilden. Dadurch ist ein Druckelement in der Form einer Flagge gebildet.

Diese Druckelementform und deren Anordnung im Raster hat den Vorteil, dass rein theoretisch ein Punkteschluss erst bei einem Halbtonwert von 100 % stattfindet. Obgleich diese Druckelementform speziell für den Vierfarbendruck entwickelt wurde, ist nach wie vor bei farbigen Abbildungen eine Moirébildung nachteilig. Dieses Erscheinungsbild kann man nur verhindern, wenn die Druckelemente für eine andere Farbe, wie Magenta, Cyan oder Gelb, gegenüber der normalen Anordnung bei Schwarz um die Mittelpunktachse verdreht werden, was recht aufwendig in der regulierenden Software ist.

Der Erfindung liegt die Aufgabe zugrunde, eine neue Druckelementform zu entwickeln, mit der noch schärfere Reproduktionen und noch feinere, weichere Verläufe in den Schattierungen möglich sind, insbesondere aber eine Moirébildung bei Farbdrucken, selbstverständlich bei der Verwendung von nur ein und derselben Form eines Druckelements nicht entsteht.

Ausgehend von den Erfahrungen mit dem Druckelement nach der EP-A-0 825 490 ist als Lösung der gestellten Aufgabe vorgesehen, dass das jeweilige Druckelement allein von S-förmigen Linien begrenzt ist und die Linien an allen Ecken des Druckelementes einen Winkel ≤ 90° einschließen. Dabei ist es besonders zweckmäßig, wenn das Druckelement nicht nur von drei, sondern besser von vier Linien begrenzt ist, weil sich dann nämlich eine Art Propeller-Figuration mit weichen geschlungen S-förmigen Linien ergibt. Damit ist eine klar definierbare geometrische Druckelementform gefunden.

Diese Figuration eines Druckelementes hat den besonderen Vorteil, dass bei einer Spiegelung des Propellers quer einer Achse durch den Mittelpunkt und die Wendepunkte zwischen den gegenüberliegenden Tal- und Berglinien ein gleich großes, gleich geformtes, Druckelement entsteht. Wenn nun die gespiegelten Druckelement mit einer anderen Farbe, vorzugsweise bei Schwarz in Kombination mit Magenta und bei Cyan in Kombination mit Gelb, gefärbt werden, entstehen keinerlei Moiréerscheinungen, was für den Vierfarbendruck von erheblichem Vorteil ist. Bei der Verwendung dieses Propeller-Druckelementes ist also die bei dem Flaggen-Druckelement notwendige Drehung des Druckelementes zur Vermeidung einer Moirébildung nicht nötig, hier muss für die andere Farbe nur der gespiegelte Propeller verwendet werden, was mit der vorhandenen Software ohne Probleme einstellbar ist. Dieses Druckelement ist für Frequenzen im Bereich zwischen 152 bis 304 lpi einsetzbar.

Selbstverständlich ist das Druckelement für den Vierfarbendruck auch ohne die Spiegelung problemlos zu verwenden. In diesem Fall ist zur Vermeidung einer Moirébildung das Druckelement - wie vorbekannt - um die Mittelachse zu verdrehen.

Damit das Druckbild unterschiedliche Helligkeitsstufen, einen sich ändernden Tonwert aufweisen können, müssen die Druckelemente von dem benachbarten durch eine Fläche getrennt sein, die nicht angefärbt ist. Diese (weiße) Flächen sind bei der Anordnung nach dieser Anmeldung stets gleichbleibend breit linienförmig, und zwar derart, dass die nebeneinander angeordneten Druckelemente des Rasters - ohne eine schachbrettartige Anordnung - einander so zugeordnet sind, dass bei jedem und auch bei sich änderndem Tonwert die Abstände der beiden benachbarten Schenkel zum nächsten Druckelement über die Länge des Schenkels konstant sind. Diese Anordnung ist die Voraussetzung für einen Punkteschluss der jeweils benachbarten Druckelemente erst bei einem Halbtonwert von etwa 100 %. Die Folge dieser Anordnung sind weiche Helligkeitsunterschiede, sind optimale Konturenschärfen bei mit diesem Druckelement hergestellten Bildern.

Dieses Druckelement ist also besonders für die farbige Reproduktion im Zeitungs-, Rollen- oder Bogenoffsetdruck vorteilhaft anzuwenden.

Die Form des erfindungsgemäßen Druckelementes ist in der Zeichnung beispielhaft dargestellt. Es zeigen:

Fig. 1    In schematischer Darstellung einen Schnitt durch die Walzen eines bekannten Offsetdruckwerks,
Fig. 2    in starker Vergrößerung in der Draufsicht ein einzelnes Propeller-Druckelement,
Fig. 3    ein Druckelement gemäß Fig. 2 zusammen mit einer Spiegelung um eine durch den Mittelpunkt des Druckelementes gehenden Achse X - X,
Fig. 4    in einer etwas verkleinerter Vergrößerung eine Anzahl von nebeneinander angeordneten Propeller Druckelementen mit gleichem Tonwert und
Fig. 5    ebenfalls in starker, jedoch gegenüber Fig. 2 oder 3 kleineren Vergrößerung eine Anzahl von unterschiedlich großen Druckelementen, also mit sich veränderndem Tonwert.

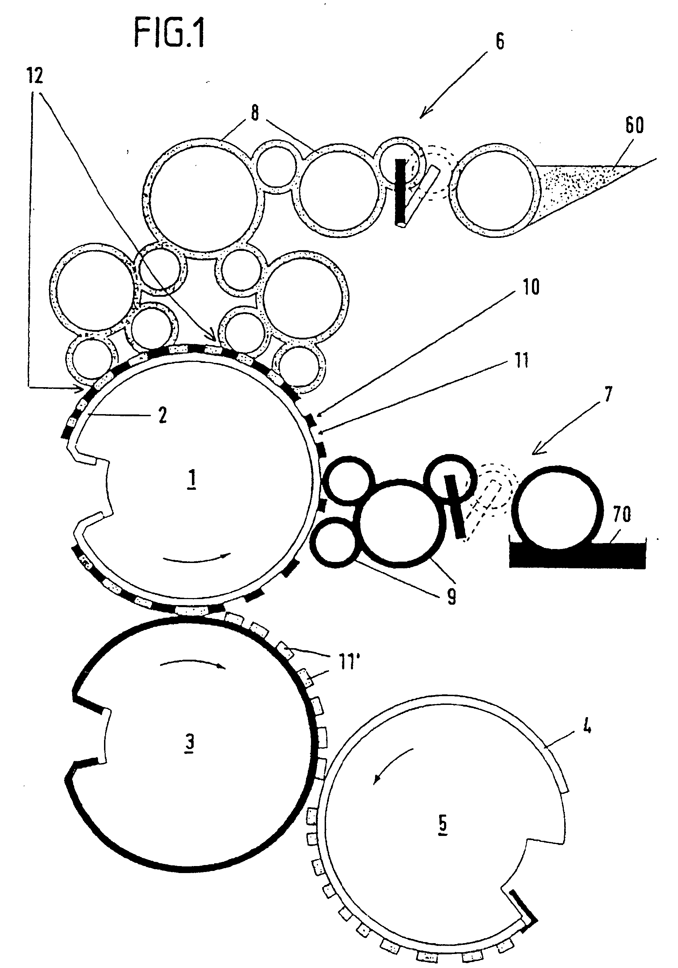

Das Offsetdruckwerk nach Fig. 1 arbeitet mit einem Plattenzylinder 1, auf den eine Druckplatte 2 aufgespannt ist. Der Plattenzylinder 1 arbeitet einerseits mit einem Gummituchzylinder 3 und dieser weiterhin mit einem mit dem zu bedruckenden Druckträger, wie Papier 4, bespannten Gegendruckzylinder 5 und andererseits mit einem Farbwerk 6 und einem Feuchtwerk 7 zusammen. Die Übertragung der Druckfarbe 60 auf die Druckplatte 2 durch das Farbwerk 6 erfolgt über eine Anzahl von Druckrollen 8. Die Übertragung des Wassers 70 durch das Feuchtwerk 7 erfolgt über eine Anzahl weiterer Übertragungswalzen 9. Alle Walzen bzw. Zylinder arbeiten gegenläufig zueinander, wie teilweise durch die Pfeile angegeben.

Durch das Feuchtwerk 7 wird Wasser 70 an nichtdruckende Stellen 10 der Druckplatte 2 übertragen, während die druckenden Stellen 11 der Druckplatte 2 von Wasser befreit bleiben. Die feuchten Stellen 10 stoßen die Druckfarbe 60 an den Auflagestellen 12 der aufliegenden Druckwalzen 8 ab, während die druckenden Stellen 11 die Druckfarbe 60 annehmen. Die Druckfarbe 60 wird dann von der Druckplatte 2 auf den Gummituchzylinder 3 übertragen und bildet dort Farbstellen 11', die schließlich auf den Druckträger 4 gedruckt werden.

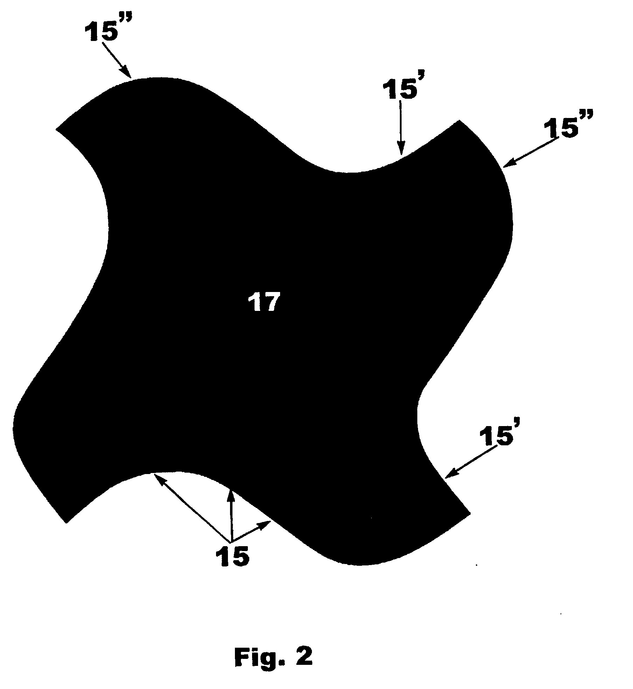

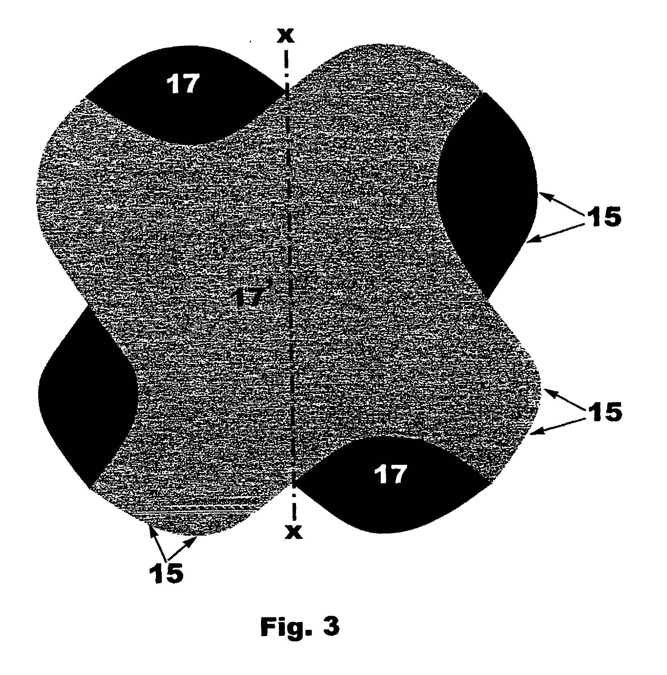

Die druckenden Stellen 11 bzw. die Farbstellen 11' sind Druckelemente gemäß Fig. 2 und 3. Diese sind in der Praxis sehr klein und mit dem bloßen Auge nicht voneinander zu trennen. Die Fig. 2 zeigt in starker Vergrößerung ein solches Druckelement in der erfindungsgemäßen Propeller-Figuration. Der Propeller hat vier S-förmige Schenkellinien 15, die alle gleich lang sind. Jede Schenkellinie beginnt an der Ecke mit einem abfallenden Liniental 15' und endet mit einem abfallenden Linienberg 15" oder in der anderen Richtung beginnt mit einem aufsteigenden Linienberg 15" und endet mit einem aufsteigenden Liniental 15'. Wenn die S-förmigen Schenkellinien alle gleich lang sind, ergibt sich an den Ecken, wo eine endende Berglinie mit einer beginnenden Tallinie zusammenstoßen, ein Winkel von 90°.

Bei dieser Figuration des Druckelementes 17 ergibt die Spiegelung ein gleichgeformtes, aber eben gespiegeltes Element, das in der Überdeckung mit der Grundfarbe nur runde Ecken zeigt. Voraussetzung ist eine Spiegelung des Druckelementes quer einer Achse X - X durch den Mittelpunkt und der Wendepunkte zwischen den gegenüberliegenden S-förmigen Linien eines Druckelementes. Die Fig. 3 zeigt eine so gespiegeltes Druckelement 17', das hier zusätzlich die gleiche Größe hat. In der Praxis können, je nach der gewünschten Mischfarbe, die Größen der beiden zusammenkommenden Druckelemente unterschiedlicher Farben auch unterschiedlich groß sein. Wesentlich ist nur, dass bei gleicher Figuration der Druckelemente und damit unveränderter Software zur Herstellung der Druckelemente Teile eines Druckelementes mit seiner eigenen Farbe ungemischt gedruckt wird, dies verhindert die Moiréerscheinungen. Wenn jetzt die notwendigen Ecken des Druckelementes nach der Spiegelung immer rund sind, ist die Moiréerscheinungen vermieden, ohne dass das Druckelement um seine Mittelachse verdreht werden muss.

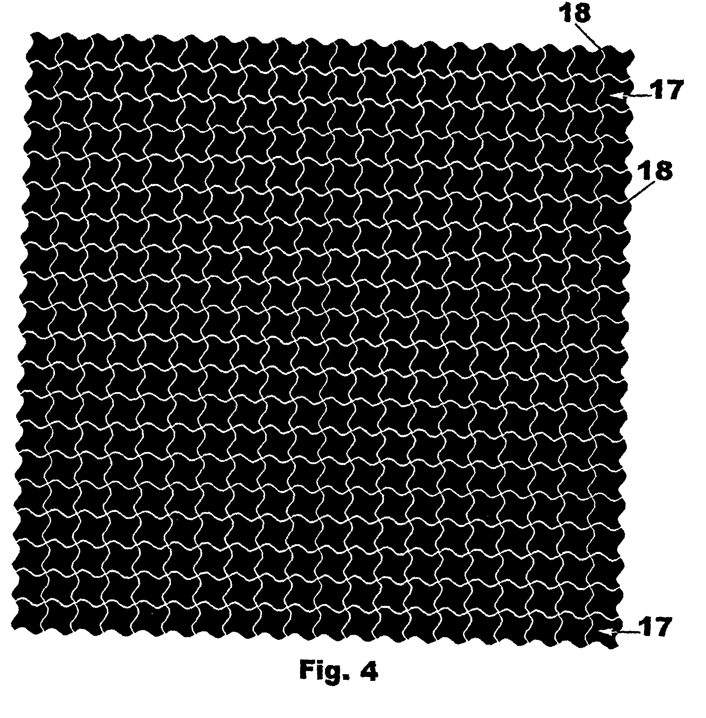

Gemäß Fig. 4 sind die propellerförmigen Druckelemente unmittelbar derart nebeneinander angeordnet, dass die Abstände der jeweils beiden Schenkel 15 der jeweils benachbarten Druckelemente immer konstant sind. Die nicht druckenden Stege 18 sind stets gleich breit. Dies ist die Voraussetzung für die Vermeidung eines Punkteschlusses bereits bei Tonwerten, die unter 100 % liegen. Bei dem propellerförmigen Druckelement, das unabhängig von einer schachbrettartigen Anordnung über die Fläche eines Druckpunktes angeordnet ist, ergibt sich nie ein Punkteschluss, es sei denn, der spezielle Druckpunkt soll exakt schwarz sein.

Zur Ergänzung ist noch auf die Fig. 5 zu verweisen, wo unverändert die propellerförmigen Druckelemente gezeichnet sind, jedoch über die Fläche der Figur 5 oder des Druckpunktes die jeweiligen Abstände zwischen den Druckelementen, also die Stege 18 sich in der Breite verändern. Damit ändert sich auch der Tonwert. Der Druckpunkt wird zur unteren Kante des Bildes heller. Die Verbreiterung der Stege kann - wie oben zu sehen - kontinuierlich oder in größeren Prozentessprüngen - wie unten zu sehen - erfolgen. Der Prozentsprung im unteren Teil des Druckpunktes ist nur größer, so dass er in dieser Auflösung stärker sichtbar ist.

## Patentansprüche

1. Druckelement zur Simulation von Tonwerten auf einem Druckträger mit einer Vielzahl von über die Fläche eines Druckpunktes verteilten Druckelementen, **dadurch gekennzeichnet, dass** das jeweilige Druckelement (17, 17') allein von S-förmigen Linien (15) begrenzt ist und die Linien an allen Ecken des Druckelementes einen Winkel $\leq$ 90° einschließen.

2. Druckelement nach Anspruch 1, **dadurch gekennzeichnet, dass** das Druckelement (17, 17') mindestens drei Schenkellinien (15) aufweist.

3. Druckelement nach einem der vorhergehenden Ansprüche, **dadurch gekennzeichnet, dass** jede Schenkellinie (15) an der Ecke mit einem abfallenden Liniental (15') beginnt und mit einem abfallenden Linienberg (15") endet oder umgekehrt mit einem aufsteigenden Linienberg (15") beginnt und mit einem aufsteigenden Liniental (15') endet.

4. Druckelement nach einem der vorhergehenden Ansprüche, **dadurch gekennzeichnet, dass** die Schenkellinien des Druckelementes alle gleich lang sind.

5. Druckelement nach einem der vorhergehenden Ansprüche, **dadurch gekennzeichnet, dass** ein Druckelement von vier Schenkellinien begrenzt ist (Fig. 2).

6. Druckelement nach Anspruch 5, **dadurch gekennzeichnet, dass** das Druckelement die Form eines vierflügeligen Propellers (Fig. 2 - 5) mit gleich geformten Flügeln hat.

7. Druckelement insbesondere nach einem der vorhergehenden Ansprüche, **dadurch gekennzeichnet, dass** bei einer Spiegelung des Druckelementes (17') quer einer Achse (X - X) durch den Mittelpunkt und der Wendepunkte zwischen den gegenüberliegenden Schenkeln, wie S-förmigen Linien (15), ein gleich großes, gleich geformtes, Druckelement entsteht (Fig. 3).

8. Druckelement nach Anspruch 7, **dadurch gekennzeichnet, dass** bei einem Druckvorgang mit mehreren Farben (Vierfarbendruck) eine jeweils andere Farbe in der gespiegelten Form angefärbt ist.

9. Druckelement nach Anspruch 8 mit einem Vierfarbendruck und den Farben Schwarz, Magenta, Cyan und Gelb, **dadurch gekennzeichnet, dass** ein durch die Spiegelung ergänztes Druckelement sich durch die beiden Druk-kelemente mit der Farbe Cyan und Gelb und andererseits mit der Farbe Magenta und Schwarz ergibt.

10. Druckelement nach Anspruch 8 mit einem Vierfarbendruck und den Farben Schwarz, Magenta, Cyan und Gelb, **dadurch gekennzeichnet, dass** ein durch die Spiegelung ergänztes Druckelement sich durch die beiden Druk-kelemente mit der Farbe Cyan und Magenta und andererseits mit der Farbe Gelb und Schwarz ergibt.

11. Druckelement nach Anspruch 8 mit einem Vierfarbendruck und den Farben Schwarz, Magenta, Cyan und Gelb, **dadurch gekennzeichnet, dass** ein durch die Spiegelung ergänztes Druckelement sich durch die beiden Druk-kelemente mit der Farbe Cyan und Schwarz und andererseits mit der Farbe Magenta und Gelb ergibt.

12. Druckelement nach einem der vorhergehenden Ansprüche, **dadurch gekennzeichnet, dass** ein Druckelement von sechs Schenkellinien begrenzt ist und mehrere Druckelemente eines Druckpunktes propellerförmig zueinander angeordnet sind.

13. Druckelement nach einem der vorhergehenden Ansprüche, **dadurch gekennzeichnet, dass** die nebeneinander angeordneten Druckelemente des Druckelements - ohne eine schachbrettartige Anordnung - einander derart zugeordnet sind, dass bei jedem und auch bei sich änderndem Tonwert die Abstände (Stege 18) der beiden benachbarten S-förmigen Schenkellinien zum nächsten Druckelement über die Länge der S-förmigen Schenkellinie konstant sind.

14. Druckelement nach einem der vorhergehenden Ansprüche, **dadurch gekennzeichnet, dass** die vier Schenkellinien den folgenden Formeln entsprechen:

Die Formeln beziehen sich auf die Einheitsfläche mit den Dimensionen $x \in [-E;E]$ und $y \in [-E;E]$, wobei $E \in [0;+\infty]$ ist. Der Nullpunkt $(0;0)$ ist das Zentrum der Einheitsfläche.
Für alle Radien $r_i$ gilt:

$$i \in \{1;2;3;4;5;6;7;8\}$$

$$r1 = r2 = r3 = r4 = r5 = r6 = r7 = r8$$

$$r_i \in [E/2;+\infty]$$

Für Punkt $(x_1;y_1)$ gilt:

$$x_1 = E - \sqrt{(r_i^2 - (E/2)^2)}$$

$$y_1 = E/2$$

Für Punkt $(x_2;y_2)$ gilt:

$$x_2 = E/2$$

$$y_2 = E + \sqrt{(r_i^2 - (E/2)^2)}$$

Für Punkt $(x_3;y_3)$ gilt:

$$x_3 = -E/2$$

$$y_3 = E - \sqrt{(r_i^2 - (E/2)^2)}$$

Für Punkt $(x_4;y_4)$ gilt:

$$x_4 = -E - \sqrt{(r_i^2 - (E/2)^2)}$$

$$y_4 = E/2$$

Für Punkt $(x_5;y_5)$ gilt:

$$x_5 = -E + \sqrt{(r_i^2 - (E/2)^2)}$$

$$y_5 = -E/2$$

Für Punkt $(x_6;y_6)$ gilt:

$$x_6 = -E/2$$

$$y_6 = -E - \sqrt{(r_i^2 - (E/2)^2)}$$

Für Punkt $(x_7;y_7)$ gilt:

$$x_7 = -E/2$$

$$y_7 = -E + \sqrt{(r_i^2 - (E/2)^2)}$$

Für Punkt $(x_8;y_8)$ gilt:

$$x_8 = E + \sqrt{(r_i^2 - (E/2)^2)}$$

$$y_8 = -E/2$$

Die Punkte $(x_i;y_i)$ sind das Zentrum des jeweiligen Radius $r_i$.
Für alle Punkte $(x_i;y_i)$ gilt:

$$x_i \in [-\infty;+\infty]$$

$$y_i \in [-\infty;+\infty]$$

Diese Formeln sind richtig für ein Druckelement wie folgt:

**Claims**

1. Printing element for simulating tonal values on a printing substrate having a plurality of printing elements distributed over the area of a printing dot, **characterised in that** the individual printing element (17, 17') is bounded by S-shaped lines (15) alone and the lines include an angle $\leq 90°$ at all the corners of the printing element.

2. Printing element according to claim 1, **characterised in that** the printing element (17, 17') has at least three lines (15) forming its sides.

3. Printing element according to one of the foregoing claims, **characterised in that** each line (15) forming a side starts at the corner with a line descending into a valley (15') and ends with a line descending from a hump (15") or, the other way round, starts with a line ascending to a hump (15") and ends with a line ascending from a valley (15').

4. Printing element according to one of the foregoing claims, **characterised in that** the lines forming the sides of the printing element are all the same length.

5. Printing element according to one of the foregoing claims, **characterised in that** a printing element is bounded by four lines forming sides (Fig.2).

6. Printing element according to claim 5, **characterised in that** the printing element is in the form of a four-bladed propeller (Figs.2-5) having blades all of the same shape.

7. Printing element particularly according to one of the foregoing claims, **characterised in that** if the printing element (17') is mirrored in a direction transverse to an axis (X - X) running through the centre and the points of reversal and between the opposing sides, such as S-shaped lines (15), a printing element of the same size and shape is obtained (Fig.3).

8. Printing element according to claim 7, **characterised in that** in a printing process involving a plurality of colours (four-colour printing) the mirrored form is in each case coloured in a different colour.

9. Printing element according to claim 8, for four-colour printing in the colours black, cyan, magenta and yellow, **characterised in that** a printing element added to by mirroring is produced by two printing elements of the colours cyan and yellow and on the other hand of the colours magenta and black.

10. Printing element according to claim 8, for four-colour printing in the colours black, cyan, magenta and yellow, **characterised in that** a printing element added to by mirroring is produced by two printing elements of the colours cyan and magenta and on the other hand of the colours yellow and black.

11. Printing element according to claim 8, for four-colour printing in the colours black, cyan, magenta and yellow, **characterised in that** a printing element added to by mirroring is produced by the two printing elements of the colours cyan and black and on the other hand of the colours magenta and yellow.

12. Printing element according to one of the foregoing claims, **characterised in that** a printing element is bounded by six lines forming sides and a plurality of printing elements in a printing dot are associated with one another in propeller form.

13. Printing element according to one of the foregoing claims, **characterised in that** the printing elements which are arranged next to one another in the printing element - without being arranged in a chessboard pattern - are so associated with one another that, at any tonal value, and even when the tonal value varies, the distances (lands 18) between the two adjoining S-shaped lines forming sides and the next printing element are constant along the length of the S-shaped line forming a side.

14. Printing element according to one of the foregoing claims, **characterised in that** the four lines forming the sides obey the following formulas:

The formulas relate to the unit area of dimensions $x \in [-E;E]$ and $y \in [-E;E]$ where $E \in = [0;+ \infty]$. The zero point (0;0) is the centre of the unit area.
For all the radiuses $r_i$:

$$i \in \{1;2;3;4;5;6;7;8]$$

$$r1 = r2 = r3 = r4 = r5 = r6 = r7 = r8$$

$$r_i \in [E/2;+\infty]$$

For point $(x_1;y_1)$ :

$$x_1 = E - \sqrt{(r_i 2 - (E/2)^2)}$$

$$y_1 = E/2$$

For point $(x_2;y_2)$ :

$$x_2 = E/2$$

$$y_2 = E = \sqrt{(r_i 2 - (E/2)^2)}$$

For point $(x_3;y_3)$:

$$x_3 = -E/2$$

$$y_3 = E - \sqrt{(r_i 2 - (E/2)^2)}$$

For point $(x_4;y_4)$ :

$$x_4 = -E - \sqrt{(r_i 2 - (E/2)^2)}$$

$$y_4 = E/2$$

For point $(x_5;y_5)$ :

$$x_5 = -E + \sqrt{(r_i 2 - (E/2)^2)}$$

$$y_5 = -E/2$$

For point $(x_6;y_6)$ :

$$x_6 = -E/2$$

$$y_6 = -E - \sqrt{(r_i 2 - (E/2)^2)}$$

For point $(x_7;y_7)$ :

$$x_7 = -E/2$$

$$y_7 = -E + \sqrt{(r_i 2 - (E/2)^2)}$$

For point $(x_8;y_8)$ :

$$x_8 = E + \sqrt{(r_i^2 - (E/2)^2)}$$

$$y_8 = -E/2$$

Points $(x_i;y_i)$ are the centres of the respective radiuses $r_i$.
For all points $(x_i;y_i)$:

$$x_i \in [-\infty; +\infty]$$

$$y_i \in [-\infty; +\infty]$$

These formulas are correct for a printing element as shown below:

**Revendications**

1. Elément d'impression destiné à simuler des valeurs de nuance sur une forme imprimante dotée d'une multitude d'éléments d'impression répartis sur toute la surface d'un point d'impression, **caractérisé en que** l'élément d'impression (17, 17') est délimité exclusivement par des lignes en forme de S (15) et en ce que les lignes incluent, dans chaque coin de l'élément d'impression un angle inférieur ou égal à 90°.

2. Elément d'impression selon la revendication 1, **caractérisé en ce que** l'élément d'impression (17, 17') présente au moins trois lignes de montants (15).

3. Elément d'impression selon une des revendications précédentes, **caractérisé en ce que** chaque ligne de montant (15) commence dans le coin par une section descendante à concavité (15') et se termine par une section descendante à convexité (15'') ou inversement, la ligne de montant commençant alors par une section montante à convexité (15'') et se terminant par une section montante à concavité (15').

**4.** Elément selon une des revendications précédentes, **caractérisé en ce que** les lignes des montants de l'élément d'impression sont toutes de même longueur.

**5.** Elément d'impression selon une des revendications précédentes, **caractérisé en ce que** un élément d'impression est délimité par quatre lignes de montant (Fig. 2).

**6.** Elément d'impression selon la revendication 5, **caractérisé en ce que** l'élément d'impression se présente comme une hélice à quatre bras (Fig. 2 - 5) de forme identique.

**7.** Elément d'impression en particulier selon une des revendications précédentes, **caractérisé en ce que**, lors de la réflexion de l'élément d'impression (17') transversalement par rapport à un axe (X - X) passant par le point central et les points d'inflexion entre les montants opposés, comme les lignes en forme de S (15), un élément d'impression de taille et de forme homogène apparaît (Fig. 3).

**8.** Elément d'impression selon la revendication 7 avec impression en quadrichromie et couleurs noir, magenta, cyanure et jaune, **caractérisé en ce que**, dans le cas d'un procédé d'impression avec plusieurs couleurs (quadrichromie), la forme réfléchie présente systématiquement une autre couleur.

**9.** Elément d'impression selon la revendication 8 avec impression en quadrichromie et les couleurs noir, magenta, cyanure et jaune, **caractérisé en ce que** un élément d'impression complété par la réflexion apparaît via les deux éléments d'impression, avec, d'une part, les couleurs cyanure et jaune, et d'autre part, les couleurs magenta et noir.

**10.** Elément d'impression selon la revendication 8 avec impression en quadrichromie et les couleurs noir, magenta, cyanure et jaune, **caractérisé en ce que** un élément complété par la réflexion apparaît via les deux éléments d'impression, avec les couleurs cyanure et magenta, d'une part, et avec les couleurs jaune et noir, d'autre part.

**11.** Elément d'impression selon la revendication 8 avec impression en quadrichromie et les couleurs noir, magenta, cyanure et jaune, **caractérisé en ce que** un élément complété par la réflexion apparaît via les deux éléments d'impression, avec les couleurs cyanure et noir, d'une part, et avec les couleurs magenta et jaune, d'autre part.

**12.** Elément d'impression selon une des revendications précédentes, **caractérisé en ce qu'**un élément d'impression est délimité par six lignes de montants et **en ce que** plusieurs éléments d'impression d'un point d'impression sont reliés les uns aux autres en forme d'hélice.

**13.** Elément d'impression selon une des revendications précédentes, **caractérisé en ce que** les éléments d'impression juxtaposés de l'élément d'impression - sont reliés les uns par rapport aux autres - sans disposition en damier - de telle sorte que les distances (montants 18) entre les deux lignes de montants en forme de S et l'élément d'impression le plus proche via la longueur de la ligne de montant en forme de S soient constantes, pour chaque valeur de nuance, ainsi que pour chaque modification de cette valeur.

**14.** Elément d'impression selon une des revendications précédentes, **caractérisé en ce que** les quatre lignes de montants correspondent aux formules suivantes :

Les formules font référence à la surface unitaire avec les dimensions $x \in$ [-E ;E] et $y \in$ [-E ;E], $E \in$ [0 ; + ∞ ]. Le point zéro (0 ;0) représente le centre de la surface unitaire.
Pour tous les rayons $r_i$, la formule est : $i \in$ {1 ;2 ;3 ;4 ;5 ;6 ;7 ;8}

$$r1 = r2 = r3 = r4 = r5 = r6 = r7 = r8$$

$$r_i \in [E/2; + \infty ]$$

Pour le point (x1;y1), la formule est :

$$x_1 = E - (r_i^2 - (E/2)^2)$$

$$y_1 = E/2$$

Pour le point $(x_2; y_2)$ la formule est :

$$x_2 = E/2$$

$$y_2 = E + (r_i^2 - (E/2)^2)$$

Pour le point $(x_3; y_3)$, la formule est :

$$x_3 = - E/2$$

$$y_3 = E - (r_i^2 - (E/2)^2)$$

Pour le point $(x_4; y_4)$, la formule est :

$$x_4 = - E - (r_i^2 - (E/2)^2)$$

$$y_4 = E/2$$

Pour le point $(x_5; y_5)$, la formule est :

$$x_5 = - E + (r_i^2 - (E/2)^2)$$

$$y5 = - E/2$$

Pour le point $(x_6; y_6)$, la formule est :

$$x_6 = - E/2$$

$$y_6 = - E - (r_i^2 - (E/2)^2)$$

Pour le point $(x_7; y_7)$, la formule est :

$$x_7 = - E/2$$

$$y_7 = - E + (r_i^2 - (E/2)^2)$$

Pour le point $(x_8; y_8)$, la formule est :

$$x_8 = E + (r_i^2 - (E/2)^2)$$

$$y_8 = - E/2$$

Les points $(x_i;y_i)$ constituent le centre du rayon $r_i$. Pour tous les points $(x_i ; y_i)$, la formule est :

$$x_i \in [- \infty ; + \infty ]$$

$$y_i \in [- \infty ; + \infty ]$$

Ces formules sont d'application pour tout élément d'impression comme suit :

# FIG.1

15"

15'

15"

17

15'

15

**Fig. 2**

**Fig. 3**

18

17

18

17

Fig. 4